# EUROPEAN PATENT SPECIFICATION

(11) **EP 1 083 436 B1**
(45) Date of publication and mention of the grant of the patent: **01.06.2005**
(21) Application number: 99830559.3
(22) Date of filing: 08.09.1999
(51) Int. Cl.: G01R 31/40

(54) **Method and circuit for testing the presence of multiple supply voltages in an integrated circuit**
Verfahren und Schaltungsanordnung zum Testen der Anwesenheit von mehreren Versorgungsspannungen in einer integrierten Schaltung
Procédé et circuit de test de la présence de multiples tensions d'alimentations dans un circuit integré

(43) Date of publication of application: 14.03.2001
(73) Proprietor: STMicroelectronics S.r.l., 20041 Agrate Brianza (Milano) (IT)
(72) Inventor: Garbelli, Luigi Eugenio, 24030 Mapello (IT); Luciano, Guiseppe, 20047 Brugherio (IT); Portaluri, Salvatore, 27100 Pavia (IT)
(74) Representative: Pellegri, Alberto

(56) References cited:
- EP-A- 0 709 949
- EP-A- 0 871 037
- US-A- 5 063 303
- US-A- 5 264 782
- US-A- 5 710 701

## Description

### FIELD OF THE INVENTION

The invention relates to integrated digital circuits and in particular to the procedures for monitoring the correct presence of all supplies, a function referred to as "power monitor".

### BACKGROUND OF THE INVENTION

Modern integrated systems tend to integrate on a single chip several subsystems and power sections.

Commonly these devices employ different power supplies of the same sign and often even of opposite sign to power in the most efficient manner different circuital chip sections or the various subsystems that are integrated on the same chip.

While one or more supply voltage sources are externally provided, others are implemented internally by as many voltage regulators that are referred to one or the other of the externally generated supply voltages.

In these monolithically integrated complex systems, it is very important to monitor the level of all the different supply voltages and to generate a so-called NPOR signal stating their accordance or non accordance with the respective design values.

In case of integrated systems with one or more regulators generating as many supply voltages within the IC (integrated circuit), it may be crucial to verify that all the supply voltages either fed to the IC or generated internally have reached pre-established values before enabling the functioning of the integrated system.

Conventionally this signal is acknowledged at the end of the charging process of a capacitor charged with a relatively low constant current such to prevent the functional circuits to produce false switchings because of an insufficient supply voltage at the turn-on of the IC.

Because such a capacitor must be chargeable in a time interval of one or more milliseconds, it must be of a relatively high value and is commonly an external capacitor connected to a dedicated pin of the IC.

The assertion of the correct positioning of all the supplies of the functional circuits of the integrated system is done conventionally by forcing the NPOR signal to a high logic level.

On the other hand, many electronic systems implement a peculiar turn-on method that is commonly referred to as "soft-start" to avoid an abrupt application of the full supply voltages to the IC. Even for this well known "soft start" function a relatively slow charging of an external capacitor necessarily of large capacitance is the common way of implementation.

It is evident the burden implied by the use of distinct external capacitors, one for the "soft start" function and the other for the "power monitor" function, each one requiring a dedicated pin of the device.

### OBJECT AND SUMMARY OF THE INVENTION

The main object of the invention is provision of a method and a respective power monitor circuit to generate a NPOR signal representing the state of the power supplies while using a single external capacitor charged with a constant current by a suitable current generator integrated in the device that is used to implement a soft start function of the IC.

Essentially the method of the invention consists in:
- disabling a first discharge path of the external capacitor when the presence of the externally provided supply voltage(s) is acknowledged allowing the start of the external capacitor charge ramp towards a certain regulated voltage;
- generating by at least a first replica of charge ramp and optionally also an inverted second replica of charge ramp and supplying said replicated voltage ramps to the regulators that generate positive supply voltages and to regulators that generate negative supply voltages, respectively, actuating the soft start;
- monitoring a signal of assertion of the correctness of the values of all the externally provided and internally generated supply voltages and conditioning the continuation or the interruption of the charging of said external capacitor towards said regulated charge voltage to the overcoming of a first pre-established level of the charge voltage on the external capacitor, coinciding with the end of the soft start procedure, by keeping disabled or enabling a second discharge path of the external capacitor until said assertion signal is raised.

The end of the turn-on procedure is established by the reaching on the capacitor of a second pre-established voltage which causes a transition from low to high of a so-called NPOR signal, which will remain high as long said signal of assertion of the correctness of the values of all the power supply voltages is absent for a period of time greater than a pre-established minimum time interval.

### BRIEF DESCRIPTION OF THE DRAWINGS

**Figure 1** is a sequence of diagrams depicting the turn-on procedure of the invention in the case of a positive verification of correctness of the internally generated supply voltages;
**Figure 2** shows the same diagrams for the case of a negative verification of correctness of the internally generated supply voltages;
**Figure 3** is a basic block diagram which implements the method of the invention.

### DESCRIPTION OF AN EMBODIMENT OF THE INVENTION

The system of the invention has been successfully tested in an IC having a plurality of regulators on board. In the sample device a first supply voltage 12V and a second supply voltage 5V are applied to respective pins from external sources. A third supply voltage 3.3V is generated internally and powers a regulator generating a fourth regulated supply voltage 2.5V and a regulator generating a fifth negative supply voltage -5V.

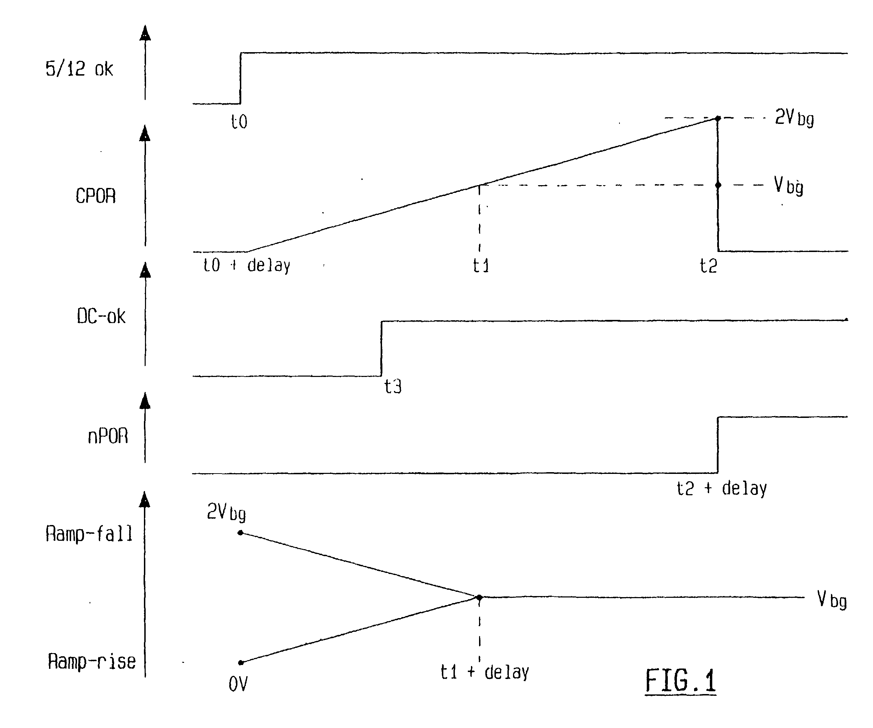

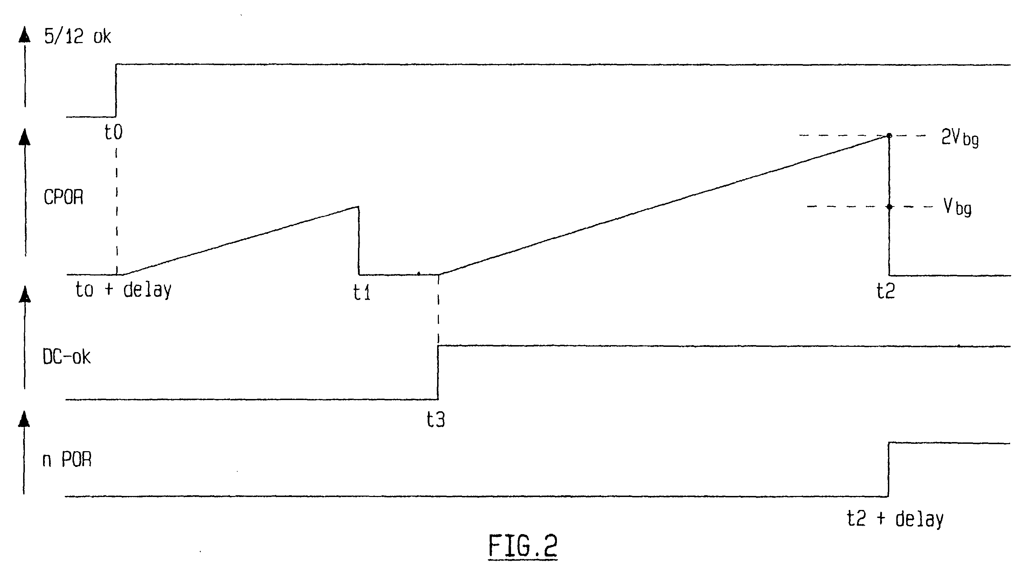

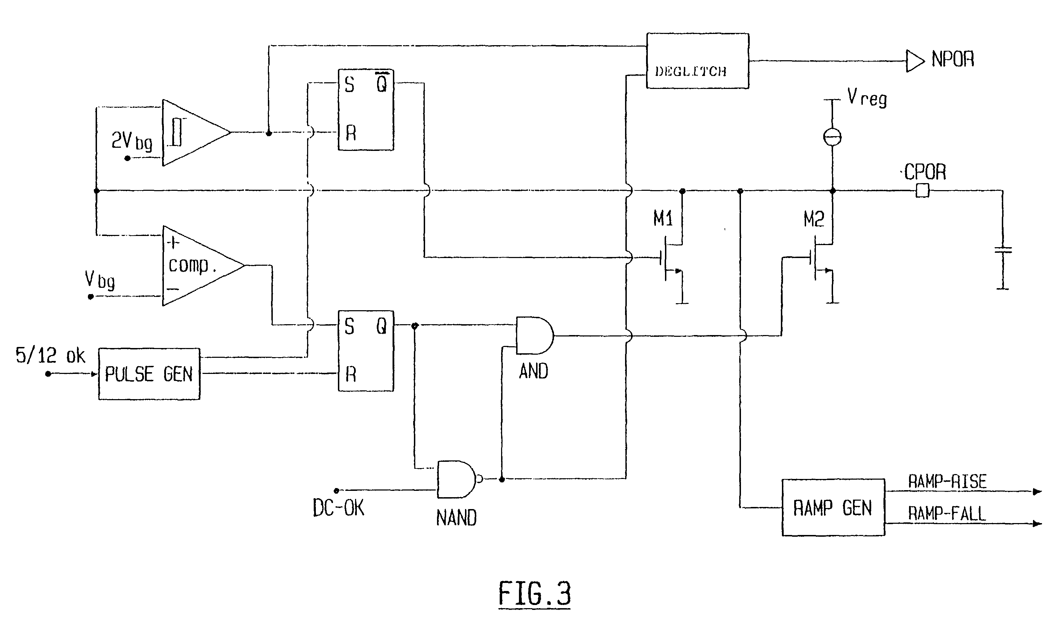

The basic diagram of a circuit according to the present invention is depicted in Fig. 3, while Figures 1 and 2 diagrammatically illustrate the algorithm of the invention for two different situations which may occur at the turn-on of the IC.

Referring to the diagram of Fig. 3, both the soft start function and the power monitor function are implemented, according to the present invention, by using a single external capacitor C, thus requiring only one pin of the device.

The capacitor C is charged by the current generator I towards a certain voltage, generically indicated as Vreg.

At the turn-on, the transistor M1 is biased in a conduction state thus maintaining discharged the external capacitor C.

Upon the rising of a first logic signal 5/12ok, asserting the application of the externally provided supply voltages to the device, the block PULSE GEN sets the register FF1, whose output $\overline{\text{Q}}$ is coupled to the control node of the transistor M1, causing its turn-off.

The PULSE GEN block, besides setting the flip-flop FF1, resets the flip-flop FF2, whose output *Q* is coupled to an input of an AND gate the output of which is coupled to the control terminal of a second transistor M2 electrically connected in parallel to the capacitor C, keeping it in an off state.

At the to instant when it is acknowledged the correct application of the externally provided supplies (5V and 12V) to the IC, the external capacitor C starts charging towards Vreg with a constant current established by the charge current generator I.

The voltage on the capacitor C is input to the block RAMP GEN which generates a direct replica and eventually a second replica of the charge ramp of the voltage on the capacitor C whose level is shifted and whose sign is inverted.

The two ramps so generated, namely: RAMP_RISE and RAMP_FALL, implement the "soft start" of the internal regulators. The initial soft start interval ends when on the external capacitor C a certain pre-established voltage of intermediate value is reached, typically the band-gap voltage Vbg.

In the illustrated example, the generator RAMP GEN generates a first ramp RAMP_RISE, who is substantially a replica of the voltage ramp developing on the external capacitor C, starting from zero up to the value of the band-gap voltage Vbg, and a second ramp RAMP_FALL falling from a shifted level of 2∗Vbg down to the Vbg level.

The soft start interval ends when the voltage on the capacitor C attains the value Vbg, event which is sensed by the comparator COMP at the instant t₁, whose output sets the second flip-flop FF2 with a minimum delay (t, + delay).

At this point, the power monitor algorithm of the invention discriminates between two distinct situations that may occur at the instant t₁ or more precisely at the instant t₁ plus a minimum switching delay of the comparator COMP which establishes the end of the soft start ramp.

A second signal DC_ok is produced in a conventional manner in the IC to assert or deny the condition that all the power supplies, that is the externally provided supply voltages (5V and 12V) and the internally generated supply voltages (3.3V, 2.5V and -5V), have a correct value.

Such a second assertion signal (flag) DC_ok is applied to a first input of a NAND gate, to the second input of which is coupled to the output *Q* of the second flip-flop FF2. The output of the NAND gate is coupled to a second input of an inverting AND gate whose output controls the second transistor M2.

In this way, if at the instant t₁ plus the switching delay of the comparator COMP, the signal DC_ok is high, confirming the correct positioning on the respective design values of all the supplies in the IC, the transistor M2 is kept in cut-off state, thus allowing the ramp charge of the capacitor C to continue until a second pre-established level is eventually reached, commonly a multiple of Vbg, in the example 2∗Vbg. Such second threshold is sufficiently high to cause the triggering of the Schmitt trigger ST whose output, by resetting the first flip-flop FF1, turns on the transistor M1 which immediately discharges the external capacitor C, ending the turn-on process and the enablement of the power monitor function by forcing the NPOR output to a high logic level.

The block DEGLITCH has the function of masking undue transitions of the NPOR signal during the normal operation of the IC that could occur because of spurious switchings of the DC_ok signal of infinitesimal duration which may be caused by accidental transient phenomena, noise coming from the mains, etc.

In practice the output of the NAND gate is applied to an input of the block DEGLITCH, who discriminates the duration of eventual switchings from the high to low state of the signal DC_ok, in practice filtering out spurious switchings having a duration shorter than a minimum pre-established time interval.

The two different situations that may happen during a turn-on process of the IC are diagrammatically shown in Figures 1 and 2.

Indeed, by accidental reasons, it may happen that at the instant t₁, the signal DC_ok has not yet been asserted (has not yet switched from low to high level).

In this case, because of the switching of the comparator COMP, the transistor M2 which discharge the capacitor C is forced in conduction state.

Thus the capacitor is kept discharged until the signal DC_ok switches to a high logic level at the instant t₃, which causes the turning-off of the transistor M2 and the start anew of the charge ramp on the external capacitor C.

As may be observed, the stated objective is fully accomplished, being the soft start and power monitor requirements perfectly satisfied by the system of the invention, using a single external capacitor C.

## Claims

1. A method for monitoring multiple supply voltages in integrated circuits part of which are externally provided and part of which, of different voltage and sign, are internally generated (12V, 5V, 3.3V, 2.5V, -5V), consisting in generating a logic signal (NPOR) monitoring the correctness of all said supply voltages after an initial soft start phase of the turn-on process, requiring the use of a single external capacitor (C) connected to a pin of the integrated circuit consisting in:
• disabling a first discharge path (M1) of the external capacitor (C) in presence of a first signal (5/12_ok) asserting the correct application to the device of the externally provided supply voltages, allowing the start of the charge ramp of the external capacitor (C) towards a certain voltage (Vreg) at a constant current (I);
• generating (RAMP GEN) at least a first voltage replica of said charge ramp (RAMP_RISE, RAMP_FALL) and supplying it to internal voltage supply generators for implementing said soft start phase;
• monitoring the presence of a second signal (DC_ok) asserting the correctness of the values of all the supply voltages, conditioning the continuation or the interruption of the voltage ramp on the capacitor (C) towards said voltage (Vref), to the reaching of a pre-established intermediate value (Vbg) by the voltage on said capacitor (C), coinciding with the end of said soft start phase, by keeping disabled or enabling a second discharge path (M2) depending upon the presence or absence of said second signal (DC_ok);
• raising said logic signal (NPOR) monitoring the correctness of all said supply voltages upon the reaching on the capacitor (C) of a second pre-established voltage value (2∗Vbg) and enabling said first discharge path (M1), ending the turn-on process;
• maintaining raised said logic signal (NPOR) as long as said second signal (DC_ok) remains absent for a period of time longer than a minimum pre-established interval.

2. A circuit for generating a logic signal (NPOR) asserting the correctness of all the supply voltages as externally provided and internally generated in an integrated circuit at the end of a soft start phase of the device using a single external capacitor (C) charged by a constant current generator (I) toward a certain voltage (Vref), a first (M1) and a second (M2) discharge transistor electrically in parallel with said external capacitor (C), a ramp generator (RAMP GEN) coupled to said external capacitor (C) generating one or more ramps (RAMP_RISE, RAMP_FALL), direct replica and/or inverted and level shifted replica of the charge ramp on said capacitor (C), a pulse generator (PULSE GEN) input with a first signal (5/12_ok) asserting the application of the externally provided supply voltage or voltages to the integrated circuit;
a first register (FF1) set (S) by the output of said pulse generator (PULSE GEN) having an output (Q) coupled to the control node of said first transistor (M1) keeping it off in presence of said first signal (5/12_ok);
a second register (FF2), reset (R) by the output of said pulse generator (PULSE GEN), having an output (Q) coupled to a first input of a first logic gate (AND) and to a first input of a second logic gate (NAND), to a second input of which is applied said second signal (DC_ok) and the output of which is coupled to a second input of said first control logic gate (AND), for keeping off said second transistor (M2) in presence of a second signal (DC_ok) asserting the correct presence of all said supply voltages;
a first comparator (COMP) of the voltage on said capacitor (C) with a first threshold voltage (Vbg), whose output is coupled to the set input (S) of said second register (FF2);
a second hysteresis comparator (SD) comparing the voltage on said capacitor (C) with a second threshold voltage (2*Vbg), having an output coupled to the reset terminal (R) of said first register (FF1) and to an input of a combinatory logic circuit (DEGLITCH) having a second input coupled to the output of said second logic gate (NAND) and outputting said logic signal (NPOR) upon the switching of said second hysteresis comparator (SD), in presence of said second signal (DC_ok), said logic circuit (DEGLITCH) maintaining said output logic signal (NPOR) as long as said second signal (DC_ok) remain absent for longer than a minimum pre-established time interval.

3. The method according to claim 1, **characterized in that** a second decreasing ramp in the form of an inverted and level shifted replica of the charge ramp of the voltage on said capacitor (C) is generated and is supplied to a circuit that generates a supply voltage of opposite sign of that of the externally provided supply voltages.

## Patentansprüche

1. Verfahren zur Überwachung mehrerer Versorgungsspannungen in integrierten Schaltungen, von denen ein Teil von außen bereitgestellt wird und von denen ein Teil mit anderer Spannung und Vorzeichen innen erzeugt wird (12 V, 5 V, 3,3 V, 2,5 V, -5 V), das in der Erzeugung eines Logiksignals (NPOR) besteht, das die Korrektheit aller Versorgungsspannungen nach einer anfänglichen weichen Startphase des Einschaltprozesses überwacht, das die Verwendung eines einzelnen äußeren Kondensators (C) erfordert, der mit einem Stift der integrierten Schaltung verbunden ist, das besteht aus:
• Sperren eines ersten Entladungswegs (M1) des äußeren Kondensators (C) beim Vorhandensein eines ersten Signals (5/12_ok), das das korrekte Anlegen an die Vorrichtung des von außen bereitgestellten Versorgungsspannungen geltend macht, wobei der Start der Laderampe des äußeren Kondensators (C) zu einer bestimmten Spannung (Vreg) mit einem konstanten Strom (I) zugelassen wird;
• Erzeugung (RAMP GEN) mindestens einer ersten Spannungskopie der Laderampe (RAMP_RISE, RAMP_FALL) und ihre Zuführung zu inneren Spannungsversorgungsgeneratoren zur Implementierung der weichen Startphase;
• Überwachung des Vorhandenseins eines zweiten Signals (DC_ok), das die Korrektheit der Werte aller Versorgungsspannungen geltend macht, das die Fortsetzung oder die Unterbrechung der Spannungsrampe am Kondensator (C) zu der Spannung (Vreg) hin bedingt, bis zum Erreichen eines zuvor festgelegten Zwischenwertes (Vbg) durch die Spannung am Kondensator (C), das mit dem Ende der weichen Startphase zusammenfällt, indem ein zweiter Entladungsweg (M2) abhängig vom Vorhandensein oder Fehlen des zweiten Signals (DC_ok) gesperrt oder freigegeben gehalten wird;
• Erhöhen des Logiksignals (NPOR), das die Korrektheit aller Versorgungsspannungen überwacht, bei Erreichen eines zweiten zuvor festgelegten Spannungswertes (2*Vbg) am Kondensator (C) und Freigeben des ersten Entladungswegs (M1), wobei der Einschaltprozeß beendet wird;
• Erhöhthalten des Logiksignals (NPOR), so lange das zweite Signal (DC_ok) für eine Zeitspanne fehlend bleibt, die kürzer als ein minimales zuvor festgelegtes Intervall ist.

2. Schaltung zur Erzeugung eines Logiksignals (NPOR), das die Korrektheit aller Versorgungsspannungen, die in einer integrierten Schaltung erzeugt werden, am Ende einer weichen Startphase der Vorrichtung geltend macht, die verwendet: einen einzelnen äußeren Kondensator (C), der durch einen Konstantstromgenerator (I) zu einer bestimmten Spannung (Vreg) hin geladen wird, einen ersten (M1) und einen zweiten (M2) Entladetransistor, die elektrisch parallel zum äußeren Kondensator (C) sind, einen Rampengenerator (RAMP GEN), der mit dem äußeren Kondensator (C) gekoppelt ist und eine oder mehrere Rampen (RAMP_RISE, RAMP_FALL), eine direkte Kopie und/oder invertierte und pegelverschobene Kopie der Laderampe am Kondensator (C) erzeugt, einen Impulsgenerator (PULSE GEN), dem ein erstes Signal (5/12_ok) zugeführt wird, das das Anlegen der von außen bereitgestellten Versorgungsspannung oder - Spannungen an die integrierte Schaltung geltend macht; ein erstes Register (FF1), das durch die Ausgabe des Impulsgenerators (PULSE GEN) gesetzt wird (S), dessen einer Ausgang (Q) mit dem Steuerknoten des ersten Transistors (M1) gekoppelt ist, der ihn beim Vorhandensein des ersten Signals (5/12_ok) ausgeschaltet hält;
ein zweites Register (FF2), das durch die Ausgabe des Impulsgenerators (PULSE GEN) rückgesetzt wird (R), dessen einer Ausgang (Q) mit dem ersten Eingang eines ersten Verknüpfungsglieds (UND) und mit einem ersten Eingang eines zweiten Verknüpfungsglieds (NAND) gekoppelt ist, an dessen zweiten Eingang das zweite Signal (DC_ok) angelegt ist und dessen Ausgang mit einem zweiten Eingang des ersten Steuerverknüpfungsglieds (UND) gekoppelt ist, um den zweiten Transistor (M2) beim Vorhandensein eines zweiten Signals (DC_ok) ausgeschaltet zu halten, das das korrekte Vorhandensein aller Versorgungsspannungen geltend macht;
einen ersten Komparator (COMP) der Spannung am Kondensator (C) mit einer ersten Schwellenspannung (Vbg), dessen Ausgang mit dem Setzeingang (S) des zweiten Registers (FF2) gekoppelt ist;
einen zweiten Hysteresekomparator (SD), der die Spannung am Kondensator (C) mit einer zweiten Schwellenspannung (2*Vbg) vergleicht, dessen Ausgang mit dem Rücksetzanschluß (R) des ersten Registers (FF1) und mit einem Eingang einer kombinatorischen Logikschaltung (DEGLITCH) gekoppelt ist, deren zweiter Eingang mit dem Ausgang des zweiten Verknüpfungsglieds (NAND) gekoppelt ist und das Logiksignal (NPOR) beim Umschalten des zweiten Hysteresekomparators (SD) ausgibt, beim Vorhandensein des zweiten Signals (DC_ok), wobei die Logikschaltung (DEGLITCH) das Ausgangslogiksignal (NPOR) aufrechterhält, so lange das zweite Signal (DC_ok) für kürzer als eine minimale zuvor festgelegtes Zeitintervall fehlend bleibt.

3. Verfahren nach Anspruch 1, **dadurch gekennzeichnet, daß** eine zweite abnehmende Rampe in der Form einer invertierten und pegelverschobenen Kopie der Laderampe der Spannung an dem Kondensator (C) erzeugt wird und einer Schaltung zugeführt wird, die eine Versorgungsspannung mit einem zu dem der von außen bereitgestellten Versorgungsspannungen entgegengesetzten Vorzeichen erzeugt.

## Revendications

1. Procédé de contrôle de tensions d'alimentation multiples dans des circuits intégrés dont une partie est alimentée de façon externe et dont une partie, de tension et de signe différents, est produite de façon interne (12V, 5V, 3,3V, 2,5V et -5V) consistant à produire un signal logique (NPOR) surveillant le caractère exact de toutes les tensions d'alimentation après une phase de démarrage progressif initial du processus de mise en route, requérant l'utilisation d'un condensateur externe unique (C) connecté à une broche du circuit intégré, comprenant les étapes suivantes :
invalider un premier trajet de décharge (M1) du condensateur externe (C) en présence d'un premier signal (S/12_ok) confirmant l'application correcte au dispositif des tensions d'alimentation fournies de façon externe, permettant le démarrage d'une rampe de charge du condensateur externe (C) vers une certaine tension (Vreg) à un courant constant (I) ;
produire (RAMP GEN) au moins une première reproduction de tension de la rampe de charge (RAMP_RISE, RAMP_FALL) et la fournir à des générateurs d'alimentation en tension internes pour réaliser la phase de démarrage progressif ;
contrôler la présence d'un second signal (DC_ok) confirmant le caractère correct des valeurs de toutes les tensions d'alimentation, conditionnant la continuation ou l'interruption de la rampe de tension sur le condensateur (C) vers ladite tension (Vreg), jusqu'à ce que la tension sur le condensateur (C) atteigne une valeur intermédiaire prédéterminée (Vbg) coïncidant avec la fin de la phase de démarrage progressif, en maintenant invalidé ou en invalidant un second trajet de décharge (M2) en fonction de la présence ou de l'absence du second signal (DC_ok) ;
élever le signal logique (NPOR) contrôlant le caractère correct de toutes les tensions d'alimentation lorsque l'on atteint sur le condensateur (C) une seconde valeur de tension prédéterminée (2*Vbg), et valider le premier trajet de décharge (M1), interrompant le processus de mise en route ; et
maintenir haut le signal logique (NPOR) tant que le second signal (DC_ok) reste absent pendant une durée inférieure à un intervalle minimum prédéterminé.

2. Circuit pour produire un signal logique (NPOR) confirmant le caractère correct de toutes les tensions d'alimentation telles que fournies de façon externe et produites de façon interne dans un circuit intégré à la fin d'une phase de démarrage progressif du dispositif en utilisant un unique condensateur externe (C) chargé par un générateur à courant constant (I) vers une certaine tension (Vreg), un premier (M1) et un second (M2) transistors de décharge électriquement en parallèle sur le condensateur externe (C), un générateur de rampe (RAMP GEN) couplé au condensateur externe (C) produisant une ou plusieurs rampes (RAMP_RISE, RAMP_FALL), des reproductions directes et/ou inversées et des reproductions décalées en niveau de la rampe de charge sur le condensateur (C), un générateur d'impulsions (PULSE GEN) recevant un premier signal (5/12_ok) confirmant l'application de la ou des tensions fournies de façon externe au circuit intégré ;
un premier registre (FF1) initialisé (S) par la sortie du générateur d'impulsions (PULSE GEN) ayant une sortie (Q) couplée au noeud de commande du premier transistor (M1) le maintenant coupé en présence du premier signal (5/12_ok) ;
un second registre (FF2), remis à zéro (R) par la sortie du générateur d'impulsions (PULSE GEN), ayant une sortie (Q) couplée à une première entrée d'une première porte logique (AND) et à une première entrée d'une seconde porte logique (NAND), à une seconde entrée de laquelle est appliqué le second signal (DC_ok) et dont la sortie est couplée à une seconde entrée de la première porte logique de commande (AND) pour maintenir coupé le second transistor (M2) en présence d'un second signal (DC_ok) confirmant la présence correcte de toutes les tensions d'alimentation ;
un premier comparateur (COMP) de la tension sur le condensateur (C) avec un premier seuil de tension (Vbg) dont la sortie est couplée à l'entrée d'initialisation (S) du second registre (FF2) ; et
un second comparateur à hystérésis (SD) comparant la tension sur le condensateur (C) à une seconde tension de seuil (2*Vbg) ayant une sortie couplée à la borne remise à zéro (R) du premier registre (FF1) et à une entrée d'un circuit logique combinatoire (DEGLITCH) ayant une seconde entrée couplée à la sortie de la seconde porte logique (NAND) et fournissant ledit signal logique (NPOR) lors de la commutation du second comparateur à hystérésis (SD), en présence du second signal (DC_ok), ledit circuit logique (DEGLITCH) maintenant le signal logique de sortie (NPOR) tant que le second signal (DC_ok) reste absent pendant moins longtemps qu'un intervalle de temps minimum prédéterminé.

3. Procédé selon la revendication 1, **caractérisé en ce qu'**une seconde rampe décroissante ayant la forme d'une réplique inversée et décalée en niveau de la rampe de charge de la tension sur le condensateur (C) est produite et est fournie à un circuit qui produit une tension d'alimentation de signe opposé à celui des tensions d'alimentation fournies de façon externe.
